# EUROPÄISCHE PATENTSCHRIFT

(11) **EP 4 461 868 B1**
(45) Veröffentlichungstag und Bekanntmachung des Hinweises auf die Patenterteilung: **19.08.2026**
(21) Anmeldenummer: 24170804.9
(22) Anmeldetag: 17.04.2024
(51) Int. Cl.: D06F 37/26, D06F 35/00

(54) **DICHTUNGSMANSCHETTE FÜR EIN HAUSHALTSGERÄT ZUR PFLEGE VON WÄSCHESTÜCKEN MIT SPEZIFISCH GEFORMTEM S-FÖRMIGEN BEREICH, SOWIE VERFAHREN UND HAUSHALTSGERÄT**
SEALING SLEEVE FOR A DOMESTIC APPLIANCE FOR THE CARE OF LAUNDRY ITEMS HAVING A SPECIFICALLY SHAPED S-SHAPED REGION, AND METHOD AND DOMESTIC APPLIANCE
MANCHETTE D'ÉTANCHÉITÉ POUR UN APPAREIL MÉNAGER DESTINÉ À L'ENTRETIEN DU LINGE, DOTÉE D'UNE ZONE EN FORME DE S DE FORME SPÉCIFIQUE, AINSI QUE PROCÉDÉ ET APPAREIL MÉNAGER

(30) Priorität: 08.05.2023 DE 102023204229
(43) Veröffentlichungstag der Anmeldung: 13.11.2024
(73) Patentinhaber: BSH Hausgeräte GmbH, 81739 München (DE)
(72) Erfinder: Li, Mingyu, 14469 Potsdam (DE)

(56) Entgegenhaltungen:
- EP-A1- 2 078 777
- DE-A1- 102006 043 922
- KR-A- 20050 081 458
- ACHENBACH M ET AL: "Entwicklung von effizienten, einfach anzuwendenden Konstruktionsprinzipien fur technische Bauteile nach dem Vorbild der Natur", 1 October 2010 (2010-10-01), pages 1 - 14, XP055773407, Retrieved from the Internet <URL:https://www.cleaner-production.de/fileadmin/assets/bilder/BMBF-Projekte/01R10638_-_Abschlussbericht.pdf or https://publikationen.bibliothek.kit.edu/310084817>

## Beschreibung

Ein Aspekt der Erfindung betrifft eine Dichtungsmanschette für ein Haushaltsgerät zur Pflege von Wäschestücken. Weitere Aspekte der Erfindung betreffen ein Herstellungsverfahren und ein Haushaltsgerät.

Bei Haushaltsgeräten zur Pflege von Wäschestücken, wie beispielsweise einer Waschmaschine oder einem Waschtrockner, ist es bekannt, dass eine ringförmige Dichtungsmanschette vorgesehen ist. Diese ringförmige Dichtungsmanschette ist insbesondere zwischen einem Laugenbehälter und einem Gehäuse des Haushaltsgeräts angeordnet, um diesbezüglich einen Spalt abzudichten.

Eine solche Dichtungsmanschette weist bekanntermaßen einen S-förmigen Bereich, wobei dies im Querschnitt betrachtet ist, auf. Ein solches Haushaltsgerät und eine solche Dichtungsmanschette sind beispielsweise aus der DE 10 2015 204 331 B4 bekannt.

Ferner offenbaren DE 10 2006 043922 A1 und KR 2005 0081458 A weitere Dichtungsmanschetten und Waschmaschinen mit solchen Dichtungsmanschetten.

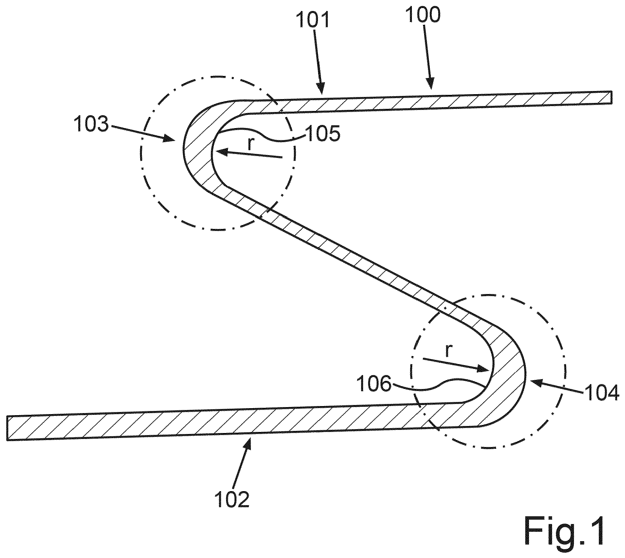

Ein im Querschnitt bekannter S-förmiger Bereich 100 ist in der Darstellung gemäß Fig. 1 gezeigt. Dieser S-förmige Bereich 100 weist zwei S-Teilebereiche beziehungsweise zwei U-artige beziehungsweise V-artige Teilbereiche 101 und 102 auf. Bei bekannten Dichtungsmanschetten 100 ist vorgesehen, dass jeweils eine Umlenkzone 103 und 104 dieser Bereiche 101 und 102 als Kreisbögen 105 und 106 konstruiert sind. Diese weisen den Radius r auf. Im Betrieb des Haushaltsgeräts treten Schwingungen auf, die auch auf diese Dichtungsmanschette, insbesondere den S-förmigen Bereich 100, übertragen werden. Da diese Dichtungsmanschette elastisch verformbar ist, treten somit auch entsprechende Verformungen dieses S-förmigen Bereichs 100 auf. Gerade in Umlaufrichtung der Lochachse dieser ringförmigen Dichtungsmanschette betrachtet, die ortsfest an dem Gehäuse und dem Laugenbehälter angeordnet ist, treten insbesondere größere Verformungen an der Drei-Uhr-Stelle und der Neun-Uhr-Stelle auf. Aufgrund der dynamischen Faltenbewegung dieses S-förmigen Bereichs 100 treten örtlich, insbesondere bei der radial äußeren Form beziehungsweise des Teilbereichs 101, Spannungsspitzen auf, die zu starken Deformationen führen und bis hin zu einem Selbstkontakt der jeweiligen Schenkel dieser Teilbereiche 101 und 102 führen können. Dabei hat sich gezeigt, dass dies auch mit fortlaufender Lebensdauer zu stärkerem Verschleiß und Ermüdung dieses S-förmigen Bereichs 100 führt. Insbesondere treten bei diesen Deformationen, insbesondere auch in der Drei-Uhr-Stellung und der Neun-Uhr-Stellung, derartige Verformungen auf, dass die jeweiligen rinnenförmigen Teilbereiche 101 und 102 vollständig deformiert werden.

Überraschenderweise hat sich dabei gezeigt, dass gerade diese Umlenkbereiche 103 und 106 mit den kreisbogenförmigen Ausgestaltungen wesentliche Zonen sind, die zu diesen Verformungen und Instabilitäten beitragen.

Ferner ist in der Veröffentlichung Achenbach et all, Schlussbericht zum BMBF-geförderten Verbundprojekt aus 2010, "Entwicklung von effizienten, einfach anzuwendenden Konstruktionsprinzipien für technische Bauteile nach dem Vorbild der Natur", Seiten 1 bis 14, DOI: 10.2314/GBV:669271837 die Methode der Zugdreiecke beschrieben.

Es ist Aufgabe der vorliegenden Erfindung, eine ringförmige Dichtungsmanschette für ein Haushaltsgerät zur Pflege von Wäschestücken, ein entsprechendes Haushaltsgerät sowie Verfahren zu schaffen, bei welchem beziehungsweise bei welchen diese ringförmige Dichtungsmanschette im Hinblick auf ihre Verformungseigenschaften bei Einwirkungen von Schwingungen verbessert ist.

Diese Aufgabe wird durch ringförmige Dichtungsmanschetten, Haushaltsgeräte und Verfahren gemäß den unabhängigen Ansprüchen gelöst.

Ein Aspekt der Erfindung betrifft eine ringförmige Dichtungsmanschette für ein Haushaltsgerät zur Pflege von Wäschestücken. Die Dichtungsmanschette weist einen im Querschnitt betrachtet S-förmigen Bereich auf. Zumindest ein rinnenförmiger Teilbereich der S-Form weist eine Parabelform auf beziehungsweise ist parabelförmig gestaltet. Durch eine solche ringförmige Dichtungsmanschette ist das Deformationsverhalten beim Einwirken von Schwingungen auf die Dichtungsmanschette deutlich reduziert. Besonders vorteilhaft ist dabei vermieden, dass Schenkel der S-Form sich selbst kontaktieren, wenn die Schwingungen auf die Dichtungsmanschette einwirken. Damit ist dieser S-förmige Bereich deutlich stabilisiert, verliert andererseits jedoch seine Funktionalität nicht, die uneingeschränkt aufrecht erhalten bleibt.

Besonders vorteilhaft ist es, dass eine Umlenkzone zumindest eines S-Teilbereichs dieses S-förmigen Bereichs eine Parabelform aufweist. Insbesondere kann in dem Zusammenhang eine Innenseite und/oder eine Außenseite dieser Umlenkzone diese Parabelform aufweisen. Damit ist zumindest eine spezifische Zone dieses S-förmigen Bereichs, insbesondere eines S-förmigen Teilbereichs, nicht mehr als Kreisbogenform gestaltet, sondern weist diesbezüglich eine Parabelform auf. Damit wird sehr vorteilhaft eine lokale Schwachstelle dieses S-förmigen Bereichs stabilisiert. Diese Formgebung hat nicht nur die Flexibilität, sondern auch die Robustheit gegen unerwünschte Deformationen, insbesondere diesen standzuhalten und behält diese S-Form auch während der Systembewegung und somit der Schwingung und deren Einwirkung bei. Auch können durch diese neue Formgebung Diagonalfalten in Anzahl und Abstand reduziert werden. Besonders vorteilhaft ist es durch diese spezifische Formgebung auch, dass das Auftreten eines Selbstkontaktierens von benachbarten Schenkeln dieses S-förmigen Bereichs und eine Ermüdung innerhalb der Falten des S-förmigen Bereichs deutlich reduziert werden kann.

In einem Ausführungsbeispiel ist die Parabelform durch eine Zugdreieckmethode konstruiert. Damit kann eine Parabelform auch sehr individuell und formpräzise gestaltet werden. Durch die Zugdreieckmethode ist eine Formgebung ermöglicht, die eine besonders hohe Stabilität im Hinblick auf verschiedenste Krafteinwirkungen ermöglicht, dennoch eine sehr vorteilhafte Elastizität insbesondere dieses S-förmigen Bereichs nicht verliert.

Insbesondere ist die durch die Zugdreieckmethode konstruierte Grundform einer Innenkontur des rinnenförmigen Teilbereichs mit einer Parabel geglättet. Damit ist die Formerzeugung im Hinblick auf die gewünschte individuelle Parabelform spezifiziert und die durch die Zugdreieckmethode erhaltene Kontur für diesen Teilbereich kann dadurch nochmals stetiger gestaltet werden und im Hinblick auf die gewünschte Parabelform besonders vorteilhaft angepasst werden.

In einem Ausführungsbeispiel weisen beide rinnenförmigen Teilbereiche der S-Form eine Parabelform auf. Die rinnenförmigen Teilbereiche der S-Form sind insbesondere die Teilbereiche der S-Form. In einem Ausführungsbeispiel kann vorgesehen sein, dass die Umlenkzonen dieser beiden rinnenförmigen Teilbereiche gleich ausgebildet sind. Sie weisen dann die gleiche Parabelform auf. Möglich ist es jedoch auch, dass diese beiden Teilbereiche, insbesondere ihre Umlenkzonen, unterschiedliche Parabelformen aufweisen. Damit kann insbesondere ein S-förmiger Bereich einer derartigen Dichtungsmanschette, die im restlichen Bereich in einem Ausführungsbeispiel dann auch gleich ausgebildet sein kann, individuell gestaltet werden. Damit können Anforderungen an die Dichtungsmanschette insbesondere im Hinblick auf den Einsatz bei unterschiedlichen Gerätetypen sehr leicht adaptiert werden.

In einem Ausführungsbeispiel ist die Dichtungsmanschette einstückig ausgebildet. Sie kann vorzugsweise aus Elastomer sein.

Ein weiterer Aspekt der Erfindung betrifft ein Verfahren zum Herstellen einer Dichtungsmanschette für ein Haushaltsgerät zur Pflege von Wäschestücken, aufweisend folgende Schritte:
- Erzeugen eines im Querschnitt S-förmigen Bereichs der ringförmigen Dichtungsmanschette, wobei der im Querschnitt S-förmige Bereich zumindest einen rinnenförmigen Teilbereich aufweist;
- Erzeugen des zumindest einen rinnenförmigen Teilbereich des S-förmigen Bereichs mit einer Parabelform.

In einem Ausführungsbeispiel wird die Parabelform auf Basis einer Zugdreieckmethode konstruiert. Besonders vorteilhaft ist es, wenn dazu das Herstellen auf Basis von Konstruktionsdaten erfolgt, wie sie durch das nachfolgend erläuterte Verfahren zum insbesondere computerimplementierten Konstruieren eines rinnenförmigen Bereichs einer Dichtungsmanschette erhalten werden.

In einem Ausführungsbeispiel werden dem Verfahren für das Herstellen Konstruktionsdaten aus einem Verfahren zum, insbesondere computerimplementierten beziehungsweise computerbasierten, Konstruieren eines rinnenförmigen Bereichs einer ringförmigen Dichtungsmanschette für ein Haushaltsgerät zur Pflege von Wäschestücken bereitgestellt, aufweisend folgende Schritte:
- Erzeugen zweier Basisschenkel, die senkrecht zueinander orientiert sind und aneinander anmünden;
- Erzeugen von mehreren gleichschenkeligen Dreiecken auf Basis der Zugdreieckmethode;
- Verbinden der Schnittpunkte, die zwischen jeweils zwei Hypotenusen von benachbarten Zugdreiecken gebildet sind, mit einer Verbindungskurve;
- Verändern der Verbindungskurve mit einer Überlagerungsfunktion, so dass aus der Verbindungskurve eine Parabelform gebildet wird.

Damit ist ein besonders vorteilhaftes Konstruktionsverfahren bereitgestellt, mit welchem die gewünschte Parabelform besonders präzise erzeugt werden kann. Insbesondere ist durch ein solches computerimplementiertes Verfahren auch dann in besonders vorteilhafter Weise ein Datensatz generierbar, auf Basis dessen entweder ein spezifisches Formwerkzeug, mit welchem dann die ringförmige Dichtungsmanschette erzeugt werden kann, sehr formpräzise im Hinblick auf die zu erzeugende Parabelform herstellbar ist. In einem alternativen Beispiel ist es dann jedoch auch möglich, mit diesem Datensatz, der einer Steuereinheit bereitgestellt werden kann, den Fertigungsprozess der ringförmigen Dichtungsmanschette sehr genau zu steuern, insbesondere dann im Hinblick auf das Erzeugen, insbesondere Gießen, des als Elastomer gebildeten S-förmigen Bereichs. Damit ist es besonders vorteilhaft, ein derartiges Erzeugen eines Datensatzes durchzuführen, um auch bei vorteilhaften und modernen Fertigungsanlagen auf Basis dieses Datensatzes dann die eigentliche Herstellung ebenfalls sehr exakt und formpräzise ermöglichen zu können.

In einem Ausführungsbeispiel wird die Herstellung des S-förmigen Bereichs auf Basis der Konstruktionsdaten durch eine Steuereinheit einer Fertigungsanlage gesteuert. Alternativ oder zusätzlich kann vorgesehen sein, dass die Herstellung des S-förmigen Bereichs auf Basis der Konstruktionsdaten dahingehend erfolgt, dass zunächst ein Fertigungswerkzeug als Negativmaske hergestellt und bereitgestellt wird, dessen Form zumindest bereichsweise auf Basis dieser Konstruktionsdaten erzeugt wurde.

Ein weiterer Aspekt der Erfindung betrifft ein Haushaltsgerät zur Pflege von Wäschestücken, mit einem Gehäuse und einem darin angeordneten Laugenbehälter. Das Haushaltsgerät weist darüber hinaus eine ringförmige Dichtungsmanschette gemäß einem oben genannten Aspekt oder einem vorteilhaften Ausführungsbeispiel davon auf. Insbesondere ist diese Dichtungsmanschette einerseits an dem Gehäuse, insbesondere direkt an dem Gehäuse, und andererseits an dem Laugenbehälter, insbesondere direkt an dem Laugenbehälter, angeordnet. Das Haushaltsgerät kann in einem Ausführungsbeispiel darüber hinaus auch eine Wäschetrommel aufweisen. Diese ist in dem Laugenbehälter aufgenommen. Vorzugsweise ist eine Beschickungsöffnung der Wäschetrommel durch eine Tür des Haushaltsgeräts, die schwenkbar an dem Gehäuse angeordnet ist, verschließbar. Insbesondere ist im geschlossenen Zustand der Tür in Tiefenrichtung des Haushaltsgeräts betrachtet die Tür überlappend mit der Dichtungsmanschette angeordnet. Die Dichtungsmanschette kann mit einer Dichtlippe an der Tür anliegen.

Weitere Merkmale der Erfindung ergeben sich aus den Ansprüchen, den Figuren und der Figurenbeschreibung. Die vorstehend in der Beschreibung genannten Merkmale und Merkmalskombinationen, sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen oder in Alleinstellung verwendbar, ohne den Rahmen der Erfindung zu verlassen. Es sind somit auch Ausführungen von der Erfindung als umfasst und offenbart anzusehen, die in den Figuren nicht explizit gezeigt und erläutert sind, jedoch durch separierte Merkmalskombinationen aus den erläuterten Ausführungen hervorgehen und erzeugbar sind. Es sind auch Ausführungen und Merkmalskombinationen als offenbart anzusehen, die somit nicht alle Merkmale eines ursprünglich formulierten unabhängigen Anspruchs aufweisen.

Ausführungsbeispiele der Erfindung werden nachfolgend anhand schematischer Zeichnungen näher erläutert. Es zeigen:
- Fig. 1: eine Querschnittdarstellung eines aus dem Stand der Technik bekannten S-förmigen Bereichs einer ringförmigen Dichtungsmanschette;
- Fig. 2: eine Vertikalschnittdarstellung durch einen Teilbereich eines Ausführungsbeispiels eines erfindungsgemäßen Haushaltsgeräts mit einem Ausführungsbeispiel einer erfindungsgemäßen Dichtungsmanschette;
- Fig. 3: eine perspektivische Darstellung eines Ausführungsbeispiels eines erfindungsgemäßen Haushaltsgeräts zur Pflege von Wäschestücken;
- Fig. 4: eine perspektivische Darstellung eines Ausführungsbeispiels einer erfindungsgemäßen ringförmigen Dichtungsmanschette;
- Fig. 5: eine perspektivische Schnittdarstellung der Dichtungsmanschette gemäß Fig. 4; und
- Fig. 6a bis 6e: eine schematische Darstellung einer Konstruktion eines S-förmigen Bereichs der Dichtungsmanschette.

In den Figuren werden gleiche oder funktionsgleiche Elemente mit den gleichen Bezugszeichen versehen.

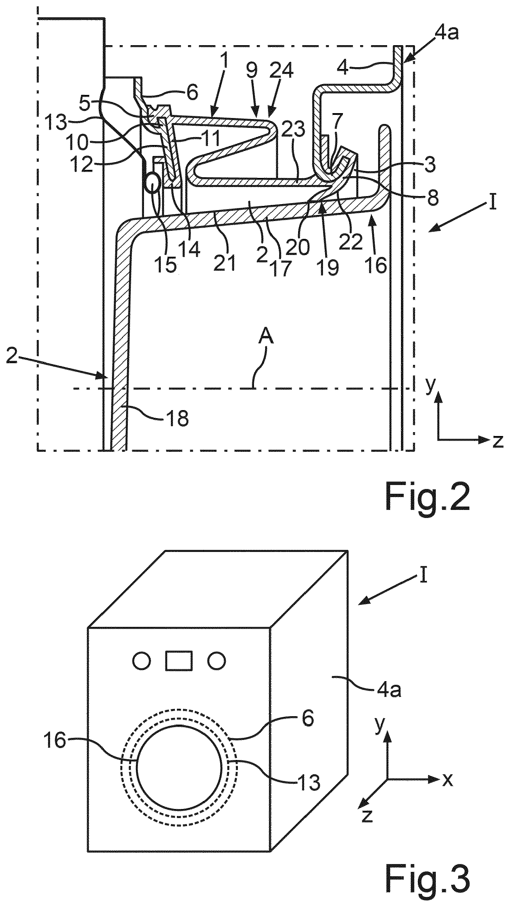

In Fig. 2 ist ein Haushaltsgerät I gezeigt, welches zur Pflege von Wäschestücken ausgebildet ist und beispielsweise eine Waschmaschine oder ein Waschtrockner sein kann. Das Haushaltsgerät I umfasst eine im Wesentlichen hohlzylindrische und ringförmige Dichtungsmanschette 1, die eine Be- und Entladeöffnung 2 radial umschließt. Die Be- und Entladeöffnung 2 stellt somit ein Ringloch dar, durch welches Wäschestücke hindurch gereicht werden können. In Richtung einer horizontal orientierten Achse A, um welche eine Trommel, die mit den Wäschestücken beladen werden kann, drehbar ist, ist die Dichtungsmanschette 1 an einem ersten Ende 3 an einer vorderen Gehäusewand 4 eines Gehäuses 4a des Haushaltsgeräts I und an einem zweiten Ende 5 an einem Laugenbehälter 6 fixiert. Dazu weist die vordere Gehäusewand 4 eine Umbördelung 7 auf, welche von einer ersten umlaufenden Wulst 8 umgriffen wird. In einem sich daran anschließenden Bereich weist die Dichtungsmanschette 1 einen zylindrischen Verlauf auf und geht schließlich in einen Faltenbalg 9 über. Dies ist jedoch nur beispielhaft zu verstehen, und die Dichtungsmanschette 1 kann diesbezüglich auch anderweitig gestaltet sein. Wesentlich ist, dass die Dichtungsmanschette 1 diesen Faltenbalg 9 aufweist, Dieser stellt ein Ausführungsbeispiel für einen im Querschnitt S-förmigen Bereich 24 der Dichtungsmanschette 1 dar.

Durch diesen beispielhaften S-förmigen Bereich 24 ist die Dichtungsmanschette 1 so flexibel gestaltet, dass sie die beim Waschvorgang oder beim Schleudervorgang bei großen Wäschemengen auftretenden Bewegungen des Laugenbehälters 6 gegenüber der vorderen Gehäusewand 4 ausgleichen kann. Darüber hinaus ist an dem zweiten Ende 5 der Dichtungsmanschette 1 eine zweite Wulst 11 vorgesehen, mit der die Dichtungsmanschette 1 an umlaufenden Rändern 10 und 12 des Laugenbehälters 6 fixiert ist.

Innerhalb des Laugenbehälters 6 ist eine während eines Waschvorgangs oder Schleudervorgangs rotierende Wäschetrommel 13 angeordnet, die während eines Schleudervorgangs die Funktion einer Schleudertrommel übernimmt und von einer Stirnseite her durch das Ringloch beschickt wird, angeordnet. Von der zweiten Wulst 11 geht eine in Längsrichtung und somit in Richtung der Achse A der Anordnung verlaufende Dichtungslamelle 14 aus und reicht bis an einen umgebördelten Rand 15 der Wäschetrommel 13.

Das in Fig. 2 dargestellte Haushaltsgerät I weist darüber hinaus eine bullaugenförmig gestaltete Tür 16 auf, die, wie im Einzelnen nicht dargestellt, an einer Seite über ein Scharnier an der vorderen Gehäusewand 4 schwenkbar angelenkt und an ihrer gegenüberliegenden Seite gegenüber der vorderen Gehäusewand 4 verriegelbar ist. Die Tür 16 ist vorzugsweise bereichsweise aus transparentem Glas ausgebildet. Dabei weist die Tür 16 einen kegelstumpfförmig verlaufenden Mantel 17 und einen kreisförmigen Boden 18 auf.

Am ersten Ende der Dichtungsmanschette 1 ist, wie in Fig. 2 zu erkennen ist, eine Dichtlippe 19 ausgebildet. Diese Dichtlippe 19 geht dabei im Wesentlichen von der ersten Wulst 8 aus in radialer Richtung nach innen und liegt bei geschlossener Tür 16 mit einer insbesondere flächigen ringförmigen Anlage 20 dichtend an einer Außenmantelfläche 21 der Tür 16 an.

Diese Dichtlippe 19 ist einstückig an einem Grundkörper 23 der Dichtungsmanschette 1 angeordnet und mündet in diesen mit einem Teil 22.

In Fig. 3 ist in einer perspektivischen Darstellung des Haushaltsgerät I, wie es zu Fig. 2 in der Schnittdarstellung erläutert wurde, gezeigt.

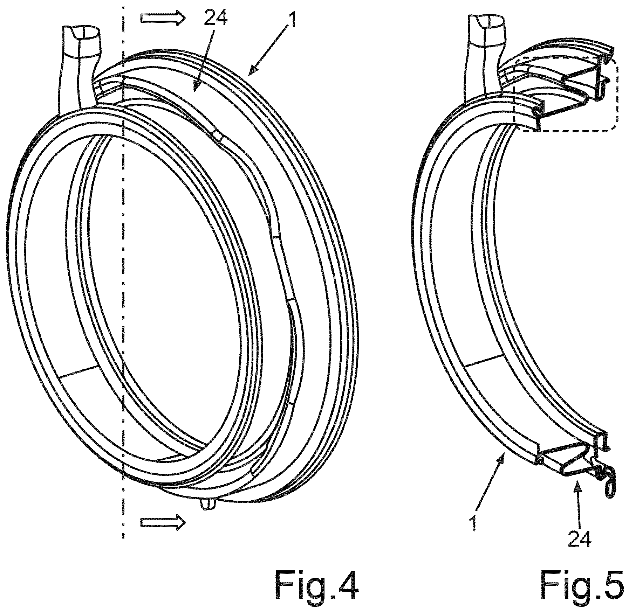

In Fig. 4 ist in einer perspektivischen Darstellung ein Ausführungsbeispiel einer ringförmigen Dichtungsmanschette 1 mit einem S-förmigen Bereich 24 dargestellt. In Fig. 5 ist diesbezüglich eine perspektivische Schnittdarstellung der Dichtungsmanschette 1 gezeigt. Der spezifisch geformte S-förmige Bereich 24 ist zu erkennen.

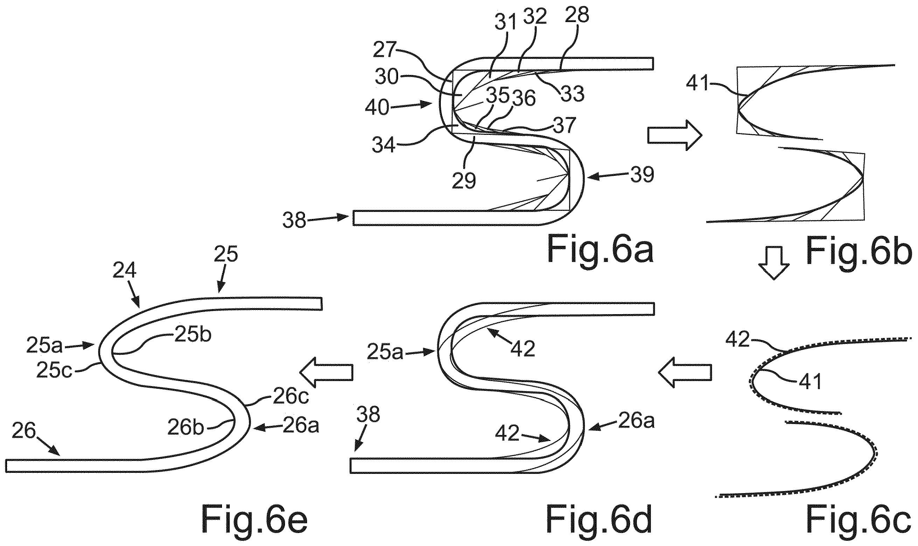

Anhand der nachfolgenden Fig. 6a bis 6e wird ein vorteilhaftes Ausführungsbeispiel zur Konstruktion und Herstellung dieses spezifischen S-förmigen Bereichs 24 erläutert. In dem Zusammenhang sei bereits auf die Querschnittdarstellung in Fig. 6e hingewiesen. Dort ist die Endform dieses S-förmigen Bereichs 24 dargestellt. Dieser weist zwei rinnenförmige Teilbereiche 25 und 26 auf. Diese stellen somit Unterbereiche der S-Form dar.

Sowohl der Teilbereich 25 als auch der Teilbereich 26 weisen Umlenkzonen 25a und 26a auf. Diese Umlenkzonen 25a und 26a weisen jeweils eine Parabelform auf. Dies gilt vorzugsweise für eine Innenseite 25b und/oder eine Innenseite 26b. Des Weiteren kann dies auch für eine Außenseite 25c und/oder 26c gelten. Diese Umlenkzonen 25a und 26a können im Hinblick auf ihre Form als Parabel gleich ausgestaltet sein. Die Parabeln dieser beiden Umlenkzonen 25a und 26a können in einem anderen Ausführungsbeispiel durchaus unterschiedlich sein. Die Dichtungsmanschette 1 ist einstückig ausgebildet, insbesondere aus Elastomer.

Bei einem vorteilhaften Verfahren zum, insbesondere computerimplementierten beziehungsweise computerbasierten, Konstruieren zumindest eines Teilbereichs 25 und/oder 26, insbesondere des gesamten S-förmigen Bereichs 24, wird in einem Ausführungsbeispiel vorzugsweise die Zugdreieckmethode zugrundegelegt. Dabei wird gemäß einem Schritt der Konstruktion, wie es in Fig. 6a gezeigt ist, ein Erzeugen von zwei aufeinander senkrechten Schenkeln 27 und 28 durchgeführt. Die hier und nachfolgend erläuterte Methode zur Konstruktion des rinnenförmigen Teilbereichs 25 gilt in einer entsprechenden Weise vorzugsweise auch für den weiteren Rinnenbereich beziehungsweise Teilbereich 26.

Darüber hinaus wird ein weiterer Basisschenkel 29 erzeugt. Die Basisschenkel 27 und 28 sind senkrecht aufeinander stehend und münden aneinander an. Insbesondere sind auch die Basisschenkel 27 und 29 senkrecht aneinander anmündend. Vorzugsweise sind die Basisschenkel 28 und 29 parallel zueinander orientiert.

Im Nachfolgenden wird dann auf Basis der Zugdreieckmethode ein Erzeugen von mehreren, gleichschenkligen Dreiecken 30, 31, 32, 33 durchgeführt. Zusätzlich kann vorzugsweise auch das Erzeugen weiterer gleichschenkliger Dreiecke 34, 35, 36 und 37 erfolgen. Auf Basis der Zugdreieckmethode ist es dabei vorgesehen, dass die Hypotenusen dieser gleichschenkligen Dreiecke aneinander anmünden. Dabei mündet ein in der Reihenfolge nachfolgendes Zugdreieck mit seiner Hypotenuse mittig an die Hypotenuse des vorhergehenden Dreiecks.

Für die Konstruktion kann in einem Ausführungsbeispiel eine streng S-förmige Grundform 38 als Vorlage genutzt werden, deren Übergangszonen beziehungsweise Umlenkzonen 39 und 40 Kreisbogen sind. Die jeweils an diese Kreisbögen anmündenden Schenkel sind geradlinig und parallel zueinander orientiert.

Ausgehend von dem in Fig. 6a erreichten Konstruktionszustand werden gemäß der Darstellung in Fig. 6b bei der weiteren Konstruktion die Schnittpunkte der aneinander anmündenden Hypotenusen mit einer Verbindungskurve 41 miteinander verbunden. Insbesondere kann dies mit einer Glattkurve erfolgen.

Nachfolgend auf diesen Verfahrensschritt, wie er in Fig. 6b gezeigt ist, wird gemäß einem weiteren vorteilhaften Schritt, wie er in Fig. 6c gezeigt ist, diese Verbindungskurve 41 mit einer Parabel angenähert. Diese modellierte Kurve wird dann gemäß einem vorteilhaften weiteren Verfahrensschritt, wie er in Fig. 6d gezeigt ist, zugrundegelegt, sodass die strenge S-Form 38 insbesondere zumindest an den Umlenkzonen 25a und 26a zu der Parabelform hin verändert wird. Insbesondere wird dabei gemäß Fig. 6d ein Verändern der Verbindungskurve 41, insbesondere mit einer Überlagerungsfunktion, an die Parabelform angenähert, sodass aus der Verbindungskurve 41 eine Parabelform 42 entsteht. Die Unterschiedlichkeit zwischen der streng ringförmigen Ausgestaltung der Umlenkzonen 39 und 40 hin zu den parabelförmigen Umlenkzonen 25a und 26a ist in Fig. 6d gezeigt. In einem vorzugsweise weiteren Schritt erfolgt dann die Finalisierung der Formgebung hin zu der dann in Fig. 6e gezeigten Endform.

Es kann vorgesehen sein, dass die in Fig. 6e gezeigte Form des S-förmigen Bereichs 24 als Datensatz bei der computerimplementierten Konstruktion vorliegt. Dieser Datensatz kann einer Fertigungsanlage zur Verfügung gestellt werden, um die Dichtungsmanschette 1, gemäß Fig. 4 und 5, herzustellen.

### Bezugszeichenliste

- I: Haushaltsgerät
- 1: Dichtungsmanschette
- 2: Be- und Entladeöffnung
- 3: erstes Ende
- 4: vordere Gehäusewand
- 4a: Gehäuse
- 5: zweites Ende
- 6: Laugenbehälter
- 7: Umbördelung
- 8: Wulst
- 9: Faltenbalg
- 10: Rand
- 11: erste Wulst
- 12: Rand
- 13: Wäschetrommel
- 14: Dichtungslamelle
- 15: umgebördelter Rand
- 16: Tür
- 17: Mantel
- 18: Boden
- 19: Dichtlippe
- 20: Anlage
- 21: Außenmantelfläche
- 22: Teil
- 23: Grundkörper
- 24: S-förmiger Bereich
- 25: Teilbereich
- 25a: Umlenkzone
- 25b: Innenseite
- 25c: Außenseite
- 26: Teilbereich
- 26a: Umlenkzone
- 26b: Innenseite
- 26c: Außenseite
- 27: Basisschenkel
- 28: Basisschenkel
- 29: Basisschenkel
- 30: gleichschenkliges Dreieck
- 31: gleichschenkliges Dreieck
- 32: gleichschenkliges Dreieck
- 33: gleichschenkliges Dreieck
- 34: gleichschenkliges Dreieck
- 35: gleichschenkliges Dreieck
- 36: gleichschenkliges Dreieck
- 37: gleichschenkliges Dreieck
- 38: Grundform
- 39: Umlenkzone
- 40: Umlenkzone
- 41: Verbindungskurve
- 42: Parabelform
- A: Achse

## Patentansprüche

1. Ringförmige Dichtungsmanschette (1) für ein Haushaltsgerät (I) zur Pflege von Wäschestücken, wobei die Dichtungsmanschette (1) einen im Querschnitt S-förmigen Bereich (24), wobei der S-förmige Bereich (24) zumindest einen rinnenförmigen Teilbereich (25, 26) aufweist, **dadurch gekennzeichnet, dass** der zumindest eine rinnenförmige Teilbereich (25, 26) des S-förmigen Bereichs (24) eine Parabelform aufweist.

2. Dichtungsmanschette (1) nach Anspruch 1, **dadurch gekennzeichnet, dass** die Parabelform durch die Zugdreieckmethode konstruiert ist.

3. Dichtungsmanschette (1) nach Anspruch 2, **dadurch gekennzeichnet, dass** die durch die Zugdreieckmethode konstruierte Grundform einer Innenkontur des rinnenförmigen Teilbereichs (25, 26) mit einer Parabel geglättet ist

4. Dichtungsmanschette (1) nach einem der vorhergehenden Ansprüche, **dadurch gekennzeichnet, dass** der S-förmige Bereich zwei rinnenförmigen Teilbereiche (25, 26) aufweist und dass beide rinnenförmigen Teilbereiche (25, 26) des S-förmigen Bereichs (24) eine Parabelform aufweisen.

5. Dichtungsmanschette (1) nach Anspruch 4, **dadurch gekennzeichnet, dass** die beiden Parabelformen gleich konstruiert sind und gleiche Form aufweisen.

6. Dichtungsmanschette (1) nach einem der vorhergehenden Ansprüche, **dadurch gekennzeichnet, dass** die Dichtungsmanschette (1) einstückig ausgebildet ist.

7. Dichtungsmanschette (1) nach einem der vorhergehenden Ansprüche, **dadurch gekennzeichnet, dass** die Dichtungsmanschette (1) aus Elastomer ist.

8. Verfahren zum Herstellen einer ringförmigen Dichtungsmanschette (1) für ein Haushaltsgerät (I) zur Pflege von Wäschestücken, aufweisend folgende Schritte:
- Erzeugen eines im Querschnitt S-förmigen Bereichs (24) der ringförmigen Dichtungsmanschette (1), wobei der im Querschnitt S-förmige Bereich (24) zumindest einen rinnenförmigen Teilbereich (25. 26) aufweist;
- Erzeugen des zumindest einen rinnenförmigen Teilbereichs (25, 26) des S-förmigen Bereichs (24) mit einer Parabelform.

9. Verfahren nach Anspruch 8, wobei die Parabelform auf Basis einer Zugdreieckmethode konstruiert wird.

10. Verfahren nach Anspruch 9, wobei für das Herstellen Konstruktionsdaten aus einem Verfahren zum, insbesondere computerimplementierten beziehungsweise computerbasierten, Konstruieren eines rinnenförmigen Bereichs (25, 26) einer ringförmigen Dichtungsmanschette (1) für ein Haushaltsgerät (I) zur Pflege von Wäschestücken bereitgestellt werden, aufweisend folgende Schritte:
- Erzeugen zweier Basisschenkel (27, 28, ,29), die senkrecht zueinander orientiert sind und aneinander anmünden;
- Erzeugen von mehreren gleichschenkeligen Dreiecken (30 bis 37) auf Basis der Zugdreieckmethode;
- Verbinden der Schnittpunkte, die zwischen jeweils zwei Hypotenusen von benachbarten Zugdreiecken (30 bis 37) gebildet sind, mit einer Verbindungskurve (41);
- Verändern der Verbindungskurve (41) mit einer Überlagerungsfunktion, so dass aus der Verbindungskurve (41) eine Parabelform gebildet wird.

11. Verfahren nach Anspruch 10, wobei die Herstellung des S-förmigen Bereichs (24) auf Basis der Konstruktionsdaten durch eine Steuereinheit einer Fertigungsanlage gesteuert wird oder ein Fertigungswerkzeug als Negativmaske bereitgestellt wird, dessen Form zumindest bereichsweise auf Basis der Konstruktionsdaten erzeugt wurde.

12. Haushaltsgerät (I) zur Pflege von Wäschestücken, mit einem Gehäuse (4a) und einem darin angeordneten Laugenbehälter (6), und mit einer ringförmigen Dichtungsmanschette (1) nach einem der vorhergehenden Ansprüche 1 bis 7 oder erhältlich durch ein Verfahren nach einem der vorhergehenden Ansprüche 8 bis 11, die an dem Gehäuse (4) und dem Laugenbehälter (6) angeordnet ist.

## Claims

1. Ring-shaped sealing sleeve (1) for a household appliance (I) for the care of laundry items, wherein the sealing sleeve (1) has an S-shaped region (24) in the cross section, wherein the S-shaped region (24) has at least one channel-shaped subregion (25, 26), **characterised in that** the at least one channel-shaped subregion (25, 26) of the S-shaped region (24) has a parabola shape.

2. Sealing sleeve (1) according to claim 1, **characterised in that** the parabola shape is constructed by way of the pull triangle method.

3. Sealing sleeve (1) according to claim 2, **characterised in that** the basic shape, constructed by way of the pull triangle method, of an inner contour of the channel-shaped subregion (25, 26) is smoothed with a parabola.

4. Sealing sleeve (1) according to one of the preceding claims, **characterised in that** the S-shaped region has two channel-shaped subregions (25, 26) and that both channel-shaped subregions (25, 26) of the S-shaped region (24) have a parabola shape.

5. Sealing sleeve (1) according to claim 4, **characterised in that** the two parabola shapes are constructed the same way and have the same shape.

6. Sealing sleeve (1) according to one of the preceding claims, **characterised in that** the sealing sleeve (1) is embodied in one piece.

7. Sealing sleeve (1) according to one of the preceding claims, **characterised in that** the sealing sleeve (1) is made of elastomer.

8. Method for producing a ring-shaped sealing sleeve (1) for a household appliance (I) for the care of laundry items, having the following steps:
- creating an S-shaped region (24) in the cross section of the ring-shaped sealing sleeve (1), wherein the S-shaped region (24) in the cross section has at least one channel-shaped subregion (25, 26);
- creating the at least one channel-shaped subregion (25, 26) of the S-shaped region (24) with a parabola shape.

9. Method according to claim 8, wherein the parabola shape is constructed on the basis of a pull triangle method.

10. Method according to claim 9, wherein, for production, construction data from a method for, in particular, computer-implemented or computer-based construction of a channel-shaped region (25, 26) of a ring-shaped sealing sleeve (1) for a household appliance (I) for the care of laundry items is provided, which method has the following steps:
- creating two base legs (27, 28, 29) which are oriented perpendicular to one another and adjoin each other;
- creating a plurality of isosceles triangles (30 to 37) on the basis of the pull triangle method;
- connecting the intersection points, which are each formed between two hypotenuses of adjacent pull triangles (30 to 37), with a connecting curve (41);
- altering the connecting curve (41) with an overlay function so that a parabola shape is formed from the connecting curve (41).

11. Method according to claim 10, wherein the production of the S-shaped region (24) is controlled by a control unit of a manufacturing plant on the basis of the construction data or a manufacturing tool is provided as a negative mask, the shape of which was created at least in regions on the basis of the construction data.

12. Household appliance (I) for the care of laundry items, with a housing (4a) and an outer tub (6) arranged therein, and with a ring-shaped sealing sleeve (1) according to one of the preceding claims 1 to 7 or which can be obtained by a method according to one of the preceding claims 8 to 11, which is arranged on the housing (4) and the outer tub (6).

## Revendications

1. Manchette d'étanchéité annulaire (1) pour un appareil électroménager (I) destinée à l'entretien de linge, dans laquelle la manchette d'étanchéité (1) présente une zone (24) transversalement en S, la zone en S (24) présentant au moins une zone partielle (25, 26) en sillon,
**caractérisée en ce que** la au moins une zone partielle (25, 26) en sillon de la zone en S (24) présente une forme parabolique.

2. Manchette d'étanchéité (1) selon la revendication 1, **caractérisée en ce que** la forme parabolique est construite par la méthode de triangle de traction.

3. Manchette d'étanchéité (1) selon la revendication 2, **caractérisée en ce que** la forme fondamentale d'un profil intérieur de la zone partiellement en sillon (25, 26) construite selon la méthode de triangle de traction est lissée par une parabole.

4. Manchette d'étanchéité (1) selon l'une des revendications précédentes, **caractérisée en ce que** la zone en S présente deux zones partielles (25, 26) en sillon et **en ce que** les deux zones partielles en sillon (25, 26) de la zone en S (24) présentent une forme parabolique.

5. Manchette d'étanchéité (1) selon la revendication 4, **caractérisée en ce que** les deux formes paraboliques sont construites de manière semblable et présentent une forme identique.

6. Manchette d'étanchéité (1) selon l'une des revendications précédentes, **caractérisée en ce que** la manchette d'étanchéité (1) est réalisée d'un seul tenant.

7. Manchette d'étanchéité (1) selon l'une des revendications précédentes, **caractérisée en ce que** la manchette d'étanchéité (1) est en élastomère.

8. Procédé de fabrication d'une manchette d'étanchéité annulaire (1) pour un appareil électroménager (I) destinée à l'entretien de linge, présentant les étapes suivantes :
- production d'une zone transversalement en S (24) de la manchette d'étanchéité annulaire (1), la zone transversalement en S (24) présentant au moins une zone partielle en sillon (25, 26) ;
- production de la au moins une zone partielle en sillon (25, 26) de la zone en S (24) avec une forme parabolique.

9. Procédé selon la revendication 8, dans lequel la forme parabolique est construite sur base d'une méthode de triangle de traction.

10. Procédé selon la revendication 9, dans lequel pour la fabrication sont fournies des données de construction d'un procédé pour la construction, en particulier mise en œuvre par ordinateur ou à base informatique, d'une zone en sillon (25, 26) d'une manchette d'étanchéité annulaire (1) pour un appareil électroménager (I) destiné à l'entretien de linge, comprenant les étapes suivantes :
- production de deux montants de base (27, 28, 29), lesquels sont orientés perpendiculairement l'un à l'autre et débouchent l'un contre l'autre ;
- production de plusieurs triangles à montants identiques (30 à 37) sur base de la méthode de triangle de traction ;
- liaison des points d'intersection, lesquels sont formés entre à chaque fois deux hypoténuses de triangles de traction (30 à 37) voisins, avec une courbe de liaison (41) ; modification de la courbe de liaison (41) avec une fonction de superposition de sorte que de la courbe de liaison (41) une forme parabolique est formée.

11. Procédé selon la revendication 10, dans lequel la fabrication de la zone en S (24) est régie sur base des données de construction par une unité de commande d'une installation de fabrication ou un outil de fabrication est procuré en tant que masque négatif, dont la forme est produite au moins en partie sur base des données de construction.

12. Appareil électroménager (I) d'entretien de linge, comprenant un châssis (4a) et une cuve à lessive (6) y agencée, et comprenant une manchette d'étanchéité annulaire (1) selon l'une des revendications précédentes 1 à 7 ou que l'on peut obtenir par un procédé selon l'une des revendications précédentes 8 à 11, laquelle est agencée au châssis (4) et à la cuve de lessivage (6).
